# Europäisches Patentamt

# European Patent Office

# Office européen des brevets

(11) Publication number: **0 055 323**
**B1**

(12) **EUROPEAN PATENT SPECIFICATION**

(45) Date of publication of patent specification: **11.11.87**

(51) Int. Cl.⁴: **H 05 K 3/34**

(21) Application number: **81106768.5**

(22) Date of filing: **29.08.81**

(54) Apparatus for soldering chip type components.

(30) Priority: **26.12.80 JP 186364/80**
**26.12.80 JP 186365/80**
**06.01.81 JP 858/81**

(43) Date of publication of application:
**07.07.82 Bulletin 82/27**

(45) Publication of the grant of the patent:
**11.11.87 Bulletin 87/46**

(84) Designated Contracting States:
**DE FR GB NL**

(56) References cited:
**EP-A-0 058 776**
**DE-A-2 255 240**
**GB-A-1 099 330**
**US-A-3 921 888**
**US-A-4 101 066**
**US-A-4 208 002**

(73) Proprietor: **Matsushita Electric Industrial Co., Ltd.**
**1006, Oaza Kadoma**
**Kadoma-shi Osaka-fu, 571 (JP)**

(72) Inventor: **Inoue, Takao**
**2-207, 46, Yamadaike Higashimachi**
**Hirakata-shi Osaka-fu (JP)**
Inventor: **Saeki, Keiji**
**3-46-203, Sengoku Higashimachi**
**Kadoma-shi Osaka-fu (JP)**
Inventor: **Matsuda, Chuichi**
**C48-103, 6, Meitoku 1-chome**
**Neyagawa-shi Osaka-fu (JP)**

(74) Representative: **Eisenführ & Speiser**
**Martinistrasse 24**
**D-2800 Bremen 1 (DE)**

**0 055 323**

**Description**

The present invention relates to an apparatus for soldering chip type components onto printed circuit boards which apparatus comprises independent first and second nozzles for spouting molten solder upwardly therefrom so as to respectively form first and second solder waves, and transport means which hold the printed circuit board for transporting said printed circuit board so as to bring an under surface of the printed circuit board into successive contact with said first and second solder waves spouted from said first and second nozzles, said second solder wave from the second nozzle located at a downstream side being arranged to be higher in the height of crest thereof than said first solder wave from said first nozzle located at an upstream side with respect to the direction of transportation of said printed circuit board, said first and second nozzles being adapted to form said first and second solder waves flowing in a direction opposite to each other, said transport means being arranged to transport said printed circuit board in a state inclined at an angle corresponding to the heights of said first and second solder waves of said first and second nozzles.

For the soldering of the chip type components as referred to above, there has conventionally been employed a spouting type soldering system in which soldering is effected by spouting or applying molten solder onto a soldering surface of a printed circuit board during movement of the printed circuit board. The spouting type soldering system as described above is broadly divided into two systems according to configurations of the spouting solder waves, i.e. one system so called as a dual or double direction solder wave spouting type in which the solder wave is formed into an approximately symmetrical configuration with respect to a spouting port or nozzle for the molten solder, and the other system referred to as a single direction solder wave spouting type which provides a solder wave flowing in a direction counter to the direction of movement of the circuit printed board.

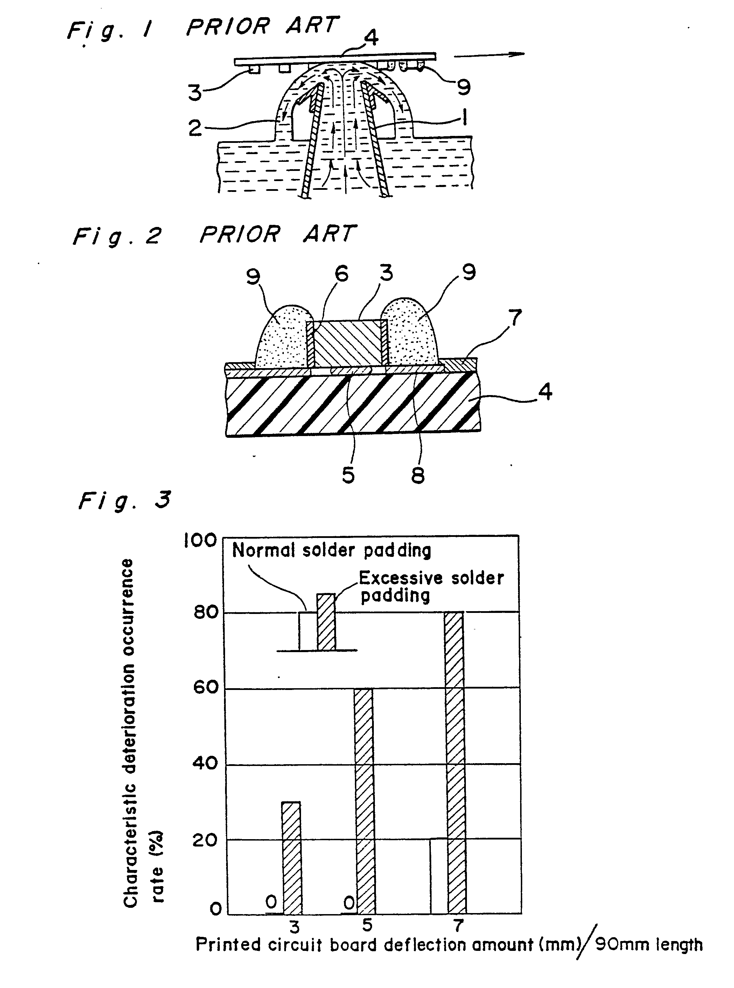

Both of the known soldering systems as described above, however, have serious disadvantages inherent therein. More specifically, in the former double direction solder wave spouting type, the solder wave 2 is spouted from the nozzle 1 in the symmetrical configuration as shown in Fig. 1, while the printed circuit board 4, on which the chip type components 3 are mounted, is moved from left to right as indicated by an arrow in the figure. In the above arangement, however, when the circuit board 4 leaves or exits from the solder wave 2, molten solder of the solder wave 2 tends to flow down in the same direction as the direction of movement of the printed circuit board 4, with excessive solder adhering to the chip type component 3, and thus, as shown in Fig. 2, excessive solder paddings i.e. fillets 9 higher in height than the chip component 3 are undesirably formed between electrode portions 6 of the chip component 3 mounted on the printed circuit board 4 by a bonding agent 5 and conductor portions 8 of the circuit board 4 surrounded by a solder resist layer 7. As is seen from a graph of Fig. 3, when the finished printed circuit board 4 is subjected to deformation (bending) due to application of an external force or heat, cracks are readily formed within the chip type component 3, which is rigidly connected to the circuit board 4 by the excessive solder paddings 9, for possible deterioration of the characteristics thereof, and thus, giving rise to malfunctions of the circuit when the circuit board 4 is to be incorporated into electronic appliances or the products are put into markets.

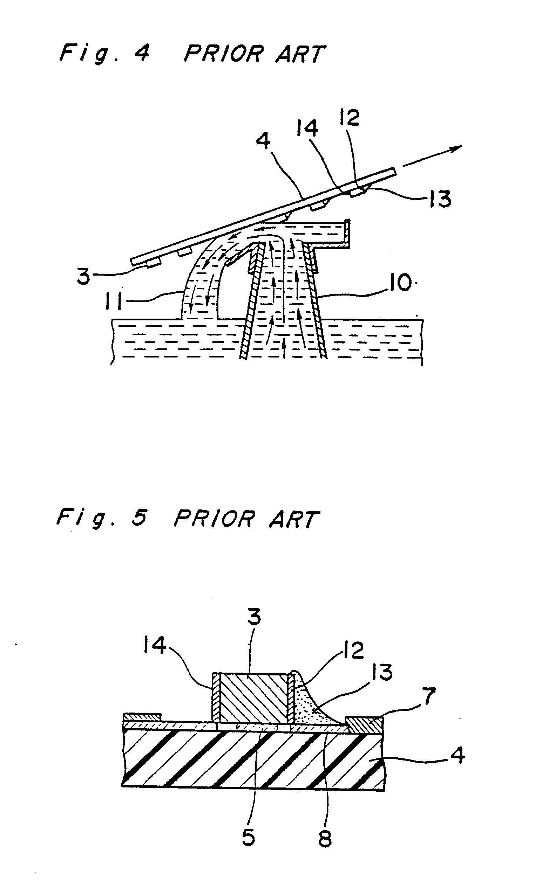

On the other hand, in the latter single direction solder wave spouting type proposed to prevent the formation of the excessive solder paddings referred to above, as shown in Fig. 4, the solder wave 11 flows from a nozzle 10 in a direction counter to the direction of movement of the printed circuit board 4, while the circuit board 4 passes through the solder wave 11 along a path inclined upwardly with respect to the direction of movement thereof. In the above arrangement, when the circuit board 4 exits from the solder wave 11, molten solder of the solder wave 11 flows down in a direction counter to the direction of the circuit board movement so as to be dragged into said solder wave 11, without forming excessive paddings or fillets. In the above arrangement, however, since the solder wave 11 is directed only to one side with respect to the chip component 3, i.e. in the direction from right to left in Fig. 4, although a normal solder padding 13 not exceeding the height of the chip type component 3 is obtained at the forward portion 12 of the component 3 with respect to the advancing direction of the circuit board 4 as shown in Fig. 5, gas of flux evaporated during the soldering undesirably stays at the rear portion 14 of the component 3 without being removed therefrom, and thus, no molten solder adheres to such rear portion 14 inevitably requiring further manual solder padding work for correction at a later stage of processing.

As is seen from the foregoing description, in both of the conventional spouting type soldering systems, faulty soldering tends to take place, thus undesirably necessitating corrections by manual operations, in which case, there is invited a still more serious problem that the chip type component is liable to be damaged by the local heating applied thereto by a soldering iron to be employed for the repairing, and therefore, it has been strongly required to provide a soldering process for chip type components in which faulty soldering is eliminated, without necessity for corrections at later stages of the processing.

An apparatus for soldering chip type components according to the features of the prior art portion of claim 1 as mentioned above is known from US—A—4,101,066. The known apparatus comprises independent first and second nozzles for spouting molten solder upwardly so as to respectively form first and second solder waves. Transport means hold the printed circuit board for transporting the printed circuit board so as to bring an under surface of the printed circuit board into successive contact with a first and second solder wave spouted from the first and second nozzles. The second solder wave spouted from

2

the second nozzle is located at a downstream side and is arranged to be higher in height of crest then the first solder wave spouted from the first nozzle located at an upstream side with the respect to the direction of transportation of the printed circuit board. The transport means is arranged to transport the printed circuit board in a state inclined at an angle corresponding to the difference in height between the first and second solder wave. However, since the first solder wave flows in a direction opposite to the direction of transportation of the printed circuit board whereas the second solder wave flows in a direction corresponding to the direction of movement of the printed circuit board.

From GB—A—10 99 330 a soldering machine for soldering printed wiring boards is known which comprises first and second nozzles for spouting molten solder upwardly from a common solder tank so as to form first and second solder waves. The printed wiring boards are fed in a horizontal position with the areas to be sold at the facing downwards such that the boards come into contact first with the solder emerging from the first nozzle and thereafter with the solder emerging from the second nozzle. Because of the substantially symmetrical configuration of the first nozzle the first solder wave is a symmetrical wave of a non-turbulent type and has a smooth surface. The asymmetrical construction and the inclined end portion of the second nozzle which is directed in a directed opposite to the proceeding direction of the printed wiring boards produces an asymmetrical wave which is directed towards the symmetrical wave spouted from the first nozzle. The height of the symmetrical wave is made such that it reaches the underside of the printed wiring board whereas the asymmetrical wave is lower than the symmetrical wave such that it hardly reaches the underside of the board. This arrangement may be preferably applied to printed wiring boards.

It is the object of the present invention to provide an apparatus for soldering chip type components onto printed circuit boards which can both assure a firm soldering and the absence of any sharp points or spikes at the rim of the chip type components even when chip type components of small size are mounted on high density on the printed circuit board.

In accomplishing this object the present invention is characterized in that said first nozzle is formed such that the first solder wave is spouted only in the direction of movement of the printed circuit board whereas said second nozzle is provided with a dam member at a front upper edge thereof so as to direct the molten solder forming said second solder wave in a direction counter to the direction of movement of the printed circuit board and that the spouting ports of said first nozzle and second nozzle are so arranged and formed that accessive solder paddings formed on the chip type component by the first solder wave are removed as they are passed through the second solder wave.

The apparatus for soldering chip type components onto printed circuit boards according to the present invention assures a firm soldering on one side and the absence of any sharp points or spikes at the rim of the chip type components even when chip type components of small size are mounted at high density on the printed circuit boards.

These and other objects and features of the present invention will become apparent from the following description taken in conjunction with the preferred embodiment thereof with reference to the accompanying drawings, in which:

Fig. 1 is a schematic side sectional view explaining the relation between solder waves and a chip type component in a conventional double direction solder wave spouting type soldering system (already referred to),

Fig. 2 is a fragmentary side sectional view on an enlarged scale, of the printed circuit board processed in the system of Fig. 1, showing the state of faulty soldering (already referred to),

Fig. 3 is a graph showing the relation between the amount of deformation of the printed circuit board and characteristic deterioration occurrence rate of the chip type component (already referred to),

Fig. 4 is a view similar to Fig. 1, which particularly shows the relation between solder wave and the chip type component in a conventional single direction solder wave spouting type soldering system (already referred to),

Fig. 5 is a fragmentary side sectional view on an enlarged scale, of the printed circuit board processed in the system of Fig. 4, showing the state of faulty soldering (already referred to),

Fig. 6 is a perspective view of a soldering apparatus according to one preferred embodiment of the present invention,

Fig. 7 is a side sectional view, on an enlarged scale, taken along the line VII—VII of Fig. 6,

Fig. 8 is a cross section taken along the line VIII—VIII of Fig. 7,

Fig. 9 is a cross section taken along the line IX—IX of Fig. 7,

Fig. 10 is a fragmentary sectional view showing part of the arrangement in Fig. 9 on a still enlarged scale,

Fig. 11 is a fragmentary side sectional view on an enlarged scale, of the printed circuit board processed by the soldering apparatus of Fig. 6 according to the present invention, showing the state of soldering of the chip type component,

Fig. 12 is a fragmentary side sectional view showing on an enlarged scale, the nozzle portions employed in the soldering apparatus of Fig. 6 for explaining the specific constructions thereof,

Fig. 13 is a view similar to Fig. 12, which particularly shows a modification thereof, and

Figs. 14 to 17 are schematic sectional diagrams for explaining dimensions of nozzle portions which may be employed in the soldering apparatus of Fig. 6.

Before the description of the present invention proceeds, it is to be noted that like parts are designated by like reference numerals throughout several views of the accompanying drawings.

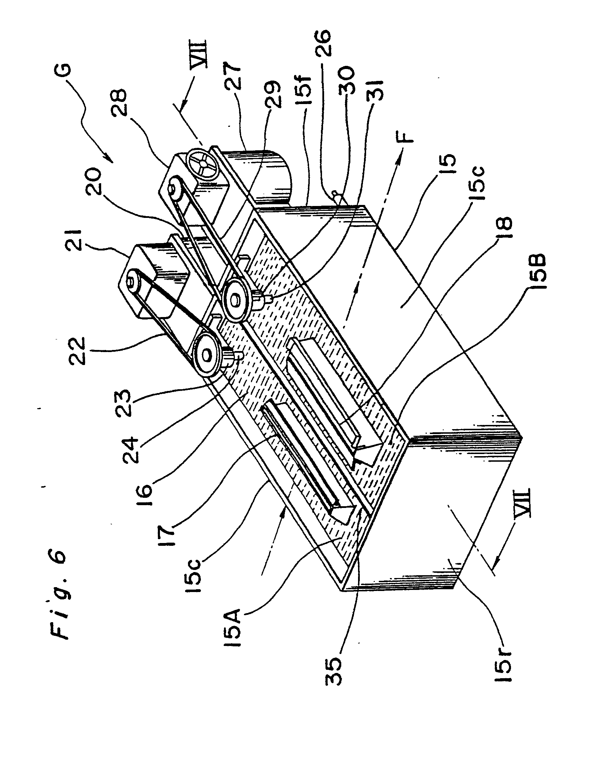

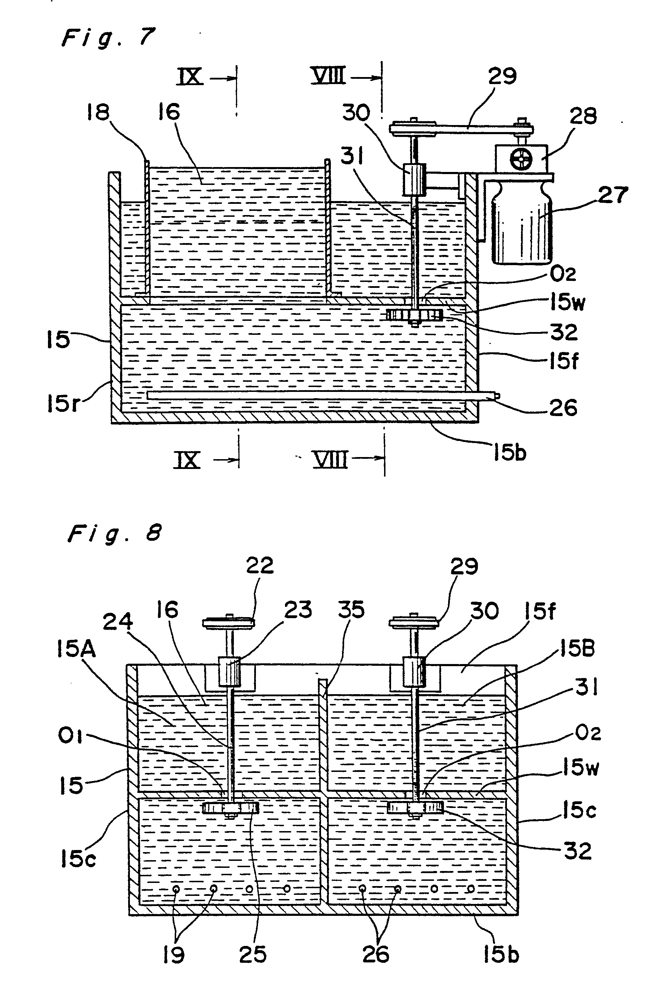

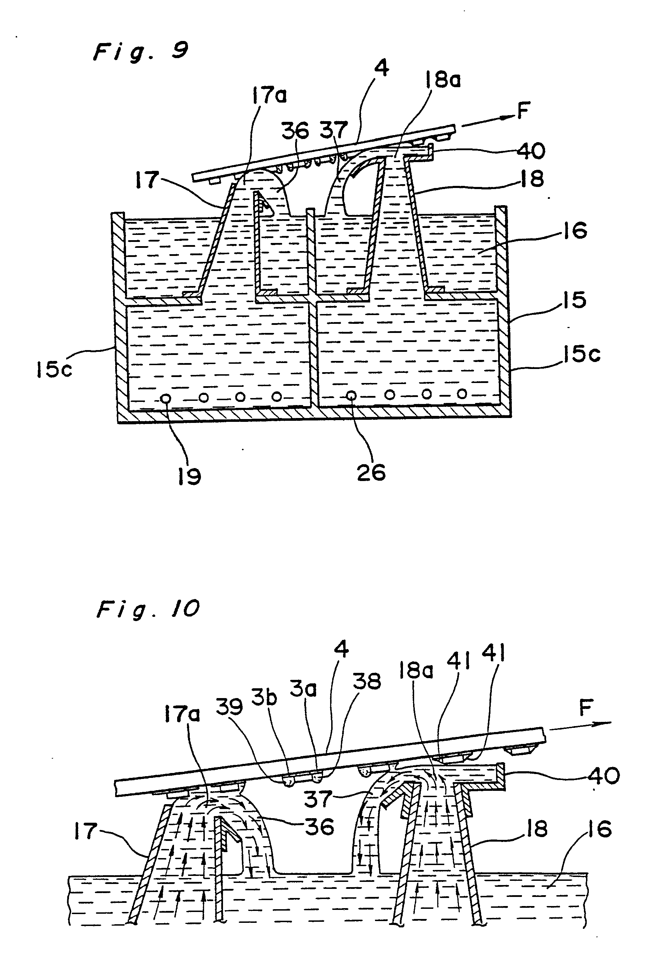

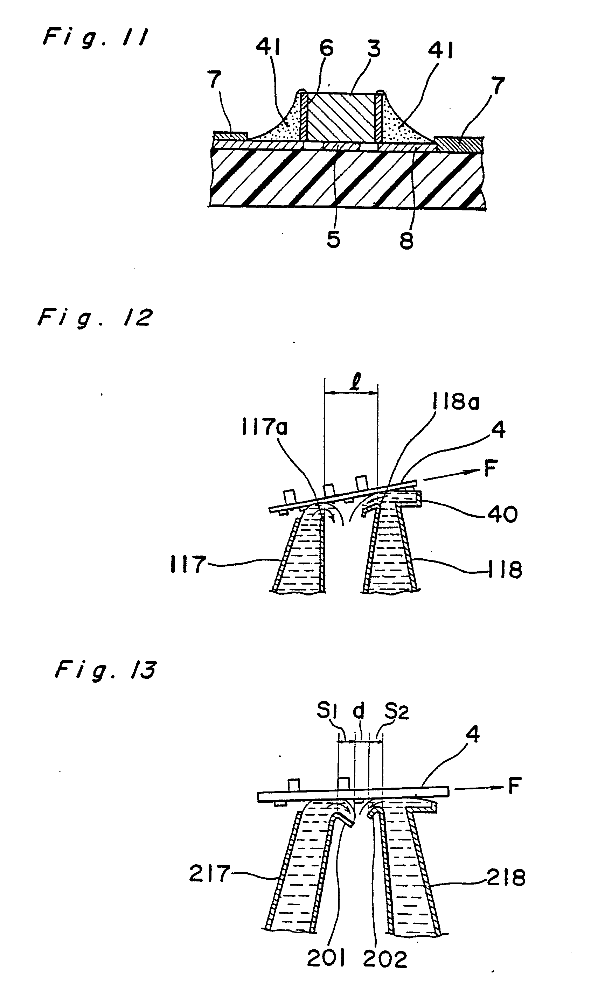

Referring now to the drawings, there is shown, in Figs. 6 through 9, a soldering apparatus G for effecting an improved soldering process according to the present invention, which generally includes a housing or container 15 of a rectangular cubic box-like configuration having front and rear walls 15f and 15r, side walls 15c, and a bottom wall 15b, in which molten solder 16 is accommodated and which is divided into two similar molten solder sump portions 15A and 15B by a partition wall 35 extending between the front and rear walls 15f and 15r in a direction parallel to the side walls 15c generally at a central portion of the container 15, each of which sump portions 15A and 15B is further divided into upper and lower portions by another partition wall 15W laterally extending between the side walls 15c of the container 15, and a first solder spouting portion or nozzle 17 and a second solder spouting portion or nozzle 18 respectively provided in the corresponding sump portions 15A and 15B in the manner as described hereinbelow. In order to cause the molten solder 16 to spout from the respective nozzles 17 and 18 in the form of solder waves, the sump portion 15A for the first nozzle 17 has heater members 19 disposed adjacent to the bottom portion thereof, and an impeller 25 fixedly mounted at the lower end of a shaft 24 which extends through a solder flow opening 01 formed in the lateral partition wall 15W of the container 15 and is rotatably supported in the sump portion 15A by a bearing member 23 secured to the front wall 15f of the container 15, and which is coupled, at its upper end, to a motor 20 fixed to the outer side face of the front wall 15f through a belt and pulley drive 22 and a speed change gear 21, while the sump portion 15B for the second nozzle 18 is similarly provided with heater members 26, and an impeller 32 fixedly mounted at the lower end of another shaft 31 which also extends through another solder flow opening 02 formed in the lateral partition wall 15W and is rotatably supported in the sump portion 15B by a bearing member 30 also secured to the front wall 15f, and which is coupled, at its upper end, to a motor 27 through a belt and pulley drive 29 and a speed change gear 28, so that the solder 16 melted by the heater members 19 and 26 is forced into the respective nozzles 17 and 18 for being spouted therefrom via the openings 01 and 02 of the lateral partition wall 15W through rotation of the impellers 25 and 32 driven by the motors 20 and 27. Consequently, the first and second nozzles 17 and 18 respectively form a first solder wave 36 and a second solder wave 37 (Figs. 9 and 10) of the molten solder 16 which is fed out by the rotation of said impellers 29 and 32, while the height of the spouting solder waves 36 and 37 may be readily altered, since the respective motors 20 and 27 are provided with the speed change gears 21 and 28.

By the above arrangement, with particular reference to Figs. 9 and 10, the printed circuit board 4, on which chip type components 3 are mounted, is advanced in the direction indicated by the arrow F and passes through the solder wave 36 from the first nozzle 17 and then, the solder wave 37 from the second nozzle 18. The molten solder 16 forming the first solder wave 36 flows down from a spouting port 17a of the first nozzle 17 in the direction of movement of the printed circuit board 4, and in this case, the solder wave 36 is applied to the front portion 3a (Fig. 10) of the chip type component 3 mounted on the circuit board 4 and forms a solder padding or fillet 38 thereat by driving away the flux gas developed. Subsequently, when the chip type component 3 exits from the solder wave 36 formed by the first nozzle 17 as the circuit board 4 advances, the solder wave 36 is also applied to the rear portion 3b of the chip type component 3, and forms a similar solder padding or fillet 39 thereat. The solder paddings 38 and 39 to be formed in the above case become excessive in the amounts thereof, since the direction of flow of the solder wave 36 is the same as the direction of movement of the printed circuit board 4. Meanwhile, at the second nozzle 18, the molten solder 16 spouted from a spouting port 18a of the second nozzle 18 is checked or stopped by a check or dam portion 40 provided at the upper front edge of the second nozzle 18 (Figs. 9 and 10), and flows down in the direction counter to the direction of movement of the printed circuit board 4 in the form of the second solder wave 37. In the above case, if it is so arranged that, the second solder wave 37 formed by the nozzle 18 is made larger in its height than the first solder wave 36, with the printed circuit board 4 being adapted to enter and leave the second solder wave 37 in a state where it is inclined or raised upwards with respect to the advancing direction thereof, the excessive solder paddings 38 and 39 formed on the chip type component 3 by the first solder wave 36 of the nozzle 17, are removed or scraped off as they are passed through the second solder wave 37 so that the extra solder thereof is fused into the second solder wave 37, and thus, the excessive solder paddings 38 and 39 are rectified or corrected into normal solder paddings 41 of a small size as shown in Fig. 11.

As is seen from the foregoing description, according to the soldering process in Figs. 9 and 10 of the present invention, such drawbacks as formation of excessive solder paddings or fillets or dewetting of solder, etc. encountered in the conventional processes are advantageously eliminated, and the optimum solder fillets of a small size not exceeding the height of the chip type component may be obtained, without requiring manual repairing or corrections at later stages of the processing.

The effects available by the present invention are given in Table 1 below, based on the results of experiments carried out by the present inventors.

TABLE 1
Soldering systems and state of occurrence of soldering faults

| Soldering system | Soldering faults | | |
|---|---|---|---|
| | Dewetting of solder | Excessive solder fillet | Solder bridge |
| Double direction wave spouting type (conventional) | 0 case | 15 cases | 4 cases |
| Single direction wave spouting type (conventional) | 11 cases | 0 case | 0 case |
| Embodiment (present invention) | 0 case | 0 case | 0 case |

In the results of the above Table 1, for the comparison between the so called double direction wave spouting type and single direction wave spouting type of the conventional soldering systems and the improved process and apparatus according to the present invention, 20 sheets each of printed circuit boards mounted with 200 pieces of chip type components per sheet, are subjected to soldering for the study on the state of occurrence of soldering faults. It is to be noted here that, "solder bridge" referred to in the above Table 1 means a soldering fault resulting from short-circuits between electrodes of neighboring chip type components, which requires manual corrections at later stages of the processing. From Table 1, it is noticed that no soldering faults have taken place in the case of the embodiment according to the present invention.

Referring further to Fig. 12, specific constructions of the first and second nozzles 17 and 18 will be described hereinbelow. More specifically, as shown in Fig. 12, a distance l between the front upper edge 117a of the first nozzle 117 and the rear upper edge 118a of the second nozzle 118 was set to 5 cm in the experiments. If the distance l is excessively short, not only a smooth flow of the molten solder 16 is unavailable, but there may be cases where the solder does not sufficiently adhere due to difficulty in efficiently releasing the gas to be developed during soldering. On the other hand, if the distance l is too large, the molten solder 16 tends to be undesirably spread as far as the upper surface of the printed circuit board 4, since the central portion of the circuit board 4 is excessively lowered or deflected downwards during passing of the board 4 through the second nozzle 118 owing to the downward warping of said circuit board 4 as it passes through the first nozzle 117. Accordingly, the distance l between the front upper edge 117a of the first nozzle 117 and the rear upper edge 118a of the second nozzle 118 is to be limited within the range practically applicable, and should desirably be larger than 3 cm and smaller than 20 cm, and more preferably, be larger than 5 cm and smaller than 15 cm.

The above arrangement described with reference to Fig. 12 may further be modified as in Fig. 13, in which control plates are provided in the vicinity of upper edges of the spouting ports for the nozzles for restricting the flow of the molten solder.

More specifically, in the arrangement of Fig. 13, at the front upper edge of the first nozzle 217 and the rear upper edge of the second nozzle 218, first and second control plates 201 and 202 of predetermined shapes are respectively provided so as to extend towards each other for efficient control of the flow of the molten solder 16. In the above modification, a distance d between the front edge of the control plate 201 provided for the first nozzle 217 and the corresponding edge of the control plate 202 provided for the second nozzle 218 should be larger than 1 cm, and more preferably, larger than 2 cm. Meanwhile, on the assumption that the lengths of the control plates 201 and 202 are respectively represented by S1 and S2, it is preferable that the relation as follows are satisfied.

$$3 \text{ cm} \leqq l \leqq 20 \text{ cm}$$
$$d \geqq 1 \text{ cm}$$
$$0 \leqq S1 \leqq 19 \text{ cm}$$
$$0 \leqq S2 \leqq 19 \text{ cm}$$

or more preferably,

$$5 \text{ cm} \leqq l \leqq 15 \text{ cm}$$
$$d \geqq 2 \text{ cm}$$
$$0 \leqq S1 \leqq 13 \text{ cm}$$
$$0 \leqq S2 \leqq 13 \text{ cm}.$$

In the above case, there is a relation represented by l=S1+S2+d among l1, S1, S2 and d.
Subsequently, effects available by the above embodiments are summarized in Table 2 below.

TABLE 2

| Example No. | l (cm) | S1 (cm) | S2 (cm) | d (cm) | (No. of spots) faulty soldering 1 | (No. of spots) faulty soldering 2 | Spreading of solder over upper surface of printed circuit board |
|---|---|---|---|---|---|---|---|
| 1 | 3 | 0 | 1 | 2 | 0 | 0 | Acceptable |
| 2 | 5 | 0 | 1 | 4 | 0 | 0 | " |
| 3 | 7 | 0 | 1 | 6 | 0 | 0 | " |
| 4 | 10 | 0 | 1 | 9 | 0 | 0 | " |
| 5 | 15 | 0 | 1 | 14 | 0 | 0 | " |
| 6 | 20 | 0 | 1 | 19 | 0 | 0 | " |
| 7 | 5 | 0 | 2 | 3 | 0 | 0 | " |
| 8 | 5 | 0 | 3 | 2 | 0 | 0 | " |
| 9 | 5 | 1 | 2 | 2 | 0 | 0 | " |
| 10 | 5 | 1 | 3 | 1 | 0 | 0 | " |
| 11 | 5 | 2 | 1 | 2 | 0 | 0 | " |
| Comparative data 1 | 2 | 0 | 1 | 1 | 5 | 0 | " |
| Comparative data 2 | 21 | 0 | 1 | 20 | 0 | 0 | Not acceptable |
| Comparative data 3 | 25 | 0 | 1 | 24 | 0 | 0 | Not acceptable |
| Conventional arrangement 1 (Fig. 1) | | | | | 1 | 13 | Acceptable |
| Conventional arrangement 2 (Fig. 2) | | | | | 8 | 4 | Acceptable |

In the experiments given in the above Table 2, paper phenol boards each 1.6 mm in thickness were employed for the printed circuit boards. "Faulty soldering 1" represents faults in which solder does not adhere to or wet the land or chip type component, while "Faulty soldering 2" denotes faults due to excessive amounts of solder fillets or solder bridge faults. The chip type components to be mounted on the printed circuit boards were set to be 125 pieces/sheet, with the results being represented on the average of five printed circuit boards. Meanwhile, the inclination of the first nozzle in the vicinity of the spouting port thereof may be so selected that the molten solder properly flows out through said spouting port in the direction of movement of said printed circuit board.

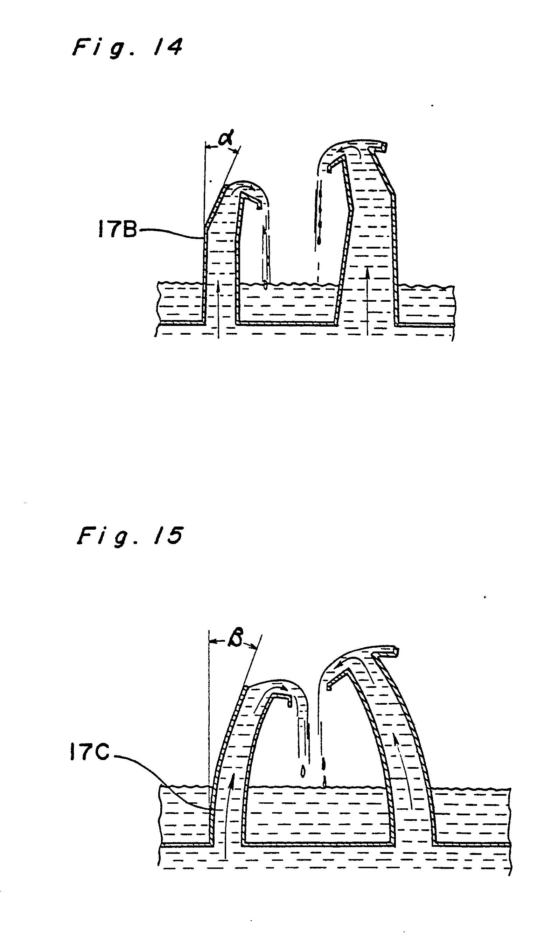

Referring also to Figs. 14 to 16, tangential angles α, β and γ at the rear edges of the first nozzles 17B, 17C and 17D of various shapes, in the vicinity of the spouting ports thereof should suitably be 2 to 80°, respectively. If the angles α, β and γ are smaller than 2°, the pressure to be applied to the electrode portion of the component is reduced as in an ordinary spouting flow, while on the contrary, if the angles α, β and γ are larger than 80°, there may arise such a problem that the end of the nozzle undesirably contacts the chip type components mounted on the printed circuit board. The above tangential angles α, β and γ should more preferably be 5 to 60°. Meanwhile, in the experiments as described above, such results were also obtained that a better soldering yield was achieved when the bending directions of the first and second nozzles were opposite to each other.

Table 3 below shows the rate of occurrence of faulty soldering with respect to a predetermined mounting density of chip type components on the printed circuit board.

TABLE 3
(Mounting density of chip type components: 3 pieces/cm²)

|  | Faulty soldering occurrence rate (%) | | | |
|---|---|---|---|---|
|  | Dewetting of solder | Solder bridge | Solder drip | Solder icicle |
| Passing twice the horizontal spouting flow | 1.0 | 0.4 | 0.9 | 0.4 |
| Arrangement of Fig. 14 | 0.1 | 0.2 | 0.4 | 0.1 |
| Arrangement of Fig. 15 | 0.2 | 0.3 | 0.3 | 0.1 |
| Arrangement of Fig. 16 | 0.4 | 0.2 | 0.2 | 0.1 |

It should be noted here that, in the foregoing embodiments, although the two nozzles 17 and 18 are arranged to be provided in one molten solder container 15 divided into the two sump portions 15A and 15B by the partition wall 35, the arrangement may of course be modified to provide the two nozzles in two separate molten solder containers one by one, with the two separate molten solder containers being disposed side by side for association so as to achieve the similar effects as in the present embodiments.

Alternatively, such two nozzles may be provided in one molten solder container without any partition wall therein so as to form separate solder waves having different heights through the two nozzles with the use of one motor and one impeller. In this case as above, the size of the solder spouting ports of the two nozzles should be altered. More specifically, by making the molten solder spouting port of the second nozzle smaller than that of the first nozzle, it is possible to render the height of the second solder wave by the second nozzle higher than that of the first solder wave, and thus, effects similar to the embodiments described earlier may also be obtained.

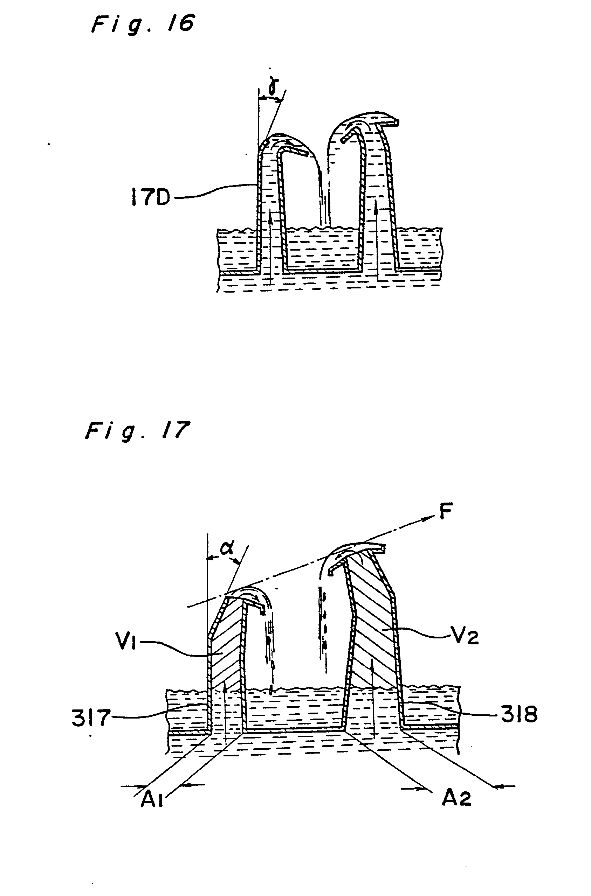

As shown in Fig. 17, the first nozzle 317 and second nozzle 318 are so constructed, in the relation between the molten solder flow-in port areas thereof, that respective area ratios are represented by a formula,

$$\frac{A1}{A2} = K\frac{V1}{V2}$$

where A1 is a solder flow-in port area for the first nozzle 317, A2 is a solder flow-in port area for the second nozzle 318 with respect to the direction F of movement of the printed circuit board, V1 and V2 are nozzle inner face volumes (hatched portions in Fig. 17) from the molten solder level to the respective solder flow-out ports, and K is a factor in the range of 0.1 to 1.2 related to the number of bending points or amount of solder leakage at the junction of sheet metals. If the reactor K is smaller than 0.1, no molten solder overflows the first nozzle, while on the other hand, if the factor K exceeds 1.2, the amount of molten solder overflowing the second nozzle is reduced.

## Claims

1. An apparatus (G) for soldering chip type components (3) onto printed circuit boards (4) which apparatus comprises independent first and second nozzles (17, 18) for spouting molten solder (16) upwardly therefrom so as to respectively form first and second solder waves (36, 37), and transport means which hold the printed circuit board (4) for transporting said printed circuit board (4) so as to bring an under surface of the printed circuit board (4) into successive contact with said first and second solder waves (36, 37) spouted from said first and second nozzles (17, 18), said second solder wave (37) from the second nozzle (18) located at a downstream side being arranged to be higher in the height of crest thereof than said first solder wave (36) from said first nozzle (17) located at an upstream side with respect to the direction of transportation of said printed circuit board (4), said first and second nozzles (17, 18) being adapted to form said first and second solder waves (36, 37) flowing in a direction opposite to each other, said transport means being arranged to transport said printed circuit board (4) in a state inclined at an angle corresponding to the heights of said first and second solder waves (36, 37) of said first and second nozzles (17, 18), characterized in that said first nozzle (17) is formed such that the first solder wave (36) is spouted only in the direction of movement of the printed circuit board (4) whereas said second nozzle (18) is provided with a dam member (40) at a front upper edge thereof so as to direct the molten solder (16) forming said second solder wave (37) in a direction counter to the direction of movement of the printed circuit board (4) and that the spouting ports (17a, 18a) of said first nozzle and second nozzle (17, 18) are so arranged and formed that accessive solder paddings (38, 39) formed on the chip type component (3) by the first solder wave (36) are removed as they are passed through the second solder wave (37).

2. An apparatus according to claim 1, characterized in that a distance between the front upper edge of said first nozzle (17) and the rear upper edge of said second nozzle (18) is set to be in the range more than 3 cm to less than 20 cm, and more preferably, more than 5 cm to less than 15 cm.

3. An apparatus according to claim 1, characterized in that the front upper edge of said first nozzle (217) and the rear upper edge of said second nozzle (218) are each provided with first and second control plates (201, 202) extending towards each other therefrom, with a distance between corresponding edges of said first and second control plates (201, 202) being set to be larger than 1 cm, and more preferably, larger than 2 cm.

4. An apparatus according to claim 3, characterized in that the dimensions of said first and second nozzles (217, 218) are in such relations as,

$$3 \text{ cm} \leqq l \leqq 20 \text{ cm}$$
$$d \geqq 1 \text{ cm}$$
$$0 \leqq S1 \leqq 19 \text{ cm}$$
$$0 \leqq S2 \leqq 19 \text{ cm}$$

and more preferably, as

$$5 \text{ cm} \leqq l \leqq 15 \text{ cm}$$
$$d \geqq 2 \text{ cm}$$
$$0 \leqq S1 \leqq 13 \text{ cm}$$
$$0 \leqq S2 \leqq 13 \text{ cm}$$

with l, S1, S2 and d being in the relation l=S1+S2+d, where l is a distance between a front upper edge of said first nozzle (217) and a rear upper edge of said second nozzle (218), S1 and S2 are each lengths of said first and second control plates (201, 202), and d is the distance between the corresponding edges of said first and second control plates (201, 202).

5. An apparatus according to claim 1, characterized in that a tangential angle at a rear edge in the vicinity of a spouting port of said first nozzle (317) is in the range from 2 to 80°, and more preferably, from 5 to 60°.

6. An apparatus according to any of the preceding claims, characterized in that said first and second nozzle (17, 18; 117, 118; 217, 218; 317, 318) are so arranged, in the relation between molten solder flow-in port areas thereof that respective area ratios are represented by a formula,

$$\frac{A1}{A2} = K \frac{V1}{V2}$$

where A1 is a solder flow-in port area for the first nozzle (17; 117; 217), A2 is a solder flow-in area for the second nozzle (18; 118; 218) with respect to the direction of movement of the printed circuit board (4), V1 and V2 are respective nozzle inner face volumes of said first and second nozzles (17, 18; 117, 118; 217, 218; 317, 318) from molten solder level to the respective solder flow-ports, and K is a factor in the range of 0,1 to 1,2.

## Patentansprüche

1. Vorrichtung zum Einlöten von chip-förmigen Bauelementen (3) in gedruckte Schaltungsplatinen (4); mit unabhängigen ersten und zweiten Düsen (17, 18) zum nach oben gerichteten Aussprudeln geschmolenen Lotes (16) zwecks Bildung von ersten und zweiten Lötwellen (36, 37); und mit einer Transporteinrichtung zum Halten und Transportieren einer gedruckten Schaltungsplatine (4) mit einer unteren Fläche in aufeinanderfolgenden Kontakt den ersten und zweiten Lötwellen (36, 37), die aus den ersten und zweiten Düsen ausgesprudelt werden; wobei die zweite Lötwelle (37) der zweiten Düse (18) stromabwärts und derart angeordnet ist, daß ihre Gipfelhöhe höher ist als die der ersten Lötwelle (36) der ersten Düse (17), die stromaufwärts gegenüber der Transportrichtung der Schaltungsplatine (4) angeordnet ist; wobei die ersten und zweiten Düsen (17, 18) so ausgebildet sind, daß sie erste und zweite Lötwellen (36, 37) bilden, die in zueinander entgegengesetzten Richtungen fließen; wobei die Transporteinrichtung derart ausgebildet ist, daß sie die gedruckte Schaltungsplatine (4) in einer um einen solchen Winkel geneigten Lage transportiert, der den Höhen der ersten und zweiten Lötwellen (36, 37) der ersten und zweiten Düsen (17, 18) entspricht, dadurch gekennzeichnet, daß die erste Düse (17) eine derartige Form hat, daß die erste Lötwelle (36) nur in der Transportrichtung der Schaltungsplatine (4) ausgesprudelt wird, während die zweite Düse (18) an ihrer vorderen Oberkante mit einer Barriere (40) versehen ist, um das geschmolzene Lot (16) zur Bildung der zweiten Lötwelle (37) in eine Richtung entgegengesetzt zur Transportrichtung der Schaltungsplatine (4) zu bringen; und daß die Aussprudelöffnungen (17a, 18a) der ersten und zweiten Düsen (17, 18) so angeordnet und ausgebildet sind, daß auf dem chipförmigen Bauelement (3) durch die erste Lötwelle (36) gebildete überschüssige Lötklumpen (38, 39) entfernt werden, wenn sie die zweite Lötwelle (37) passieren.

2. Vorrichtung nach Anspruch 1, dadurch gekennzeichnet, daß zwischen der vorderen Oberkante der ersten Düse (17) und der hinteren Oberkante der zweiten Düse (18) ein Abstand im Bereich von 3 cm bis 20 cm, vorzugsweise von 5 cm bis 15 cm, vorgesehen ist.

3. Vorrichtung nach Anspruch 1, dadurch gekennzeichnet, daß die vordere Oberkante der ersten Düse (217) und die hintere Oberkante der zweiten Düse (218) jede mit ersten und zweiten Steuerplatten (201, 202) versehen sind, die aufeinander zu gerichtet sind und zwischen entsprechenden Kanten einen Abstand aufweisen, der größer als 1 cm, vorzugsweise größer als 2 cm, ist.

4. Vorrichtung nach Anspruch 3, dadurch gekennzeichnet, daß die Abmessungen der ersten und zweiten Düsen (217, 218) in folgenden Beziehungen zueinander stehen:

$$3 \text{ cm} \leqq I \leqq 20 \text{ cm}$$
$$d \geqq 1 \text{ cm}$$
$$0 \leqq S1 \leqq 19 \text{ cm}$$
$$0 \leqq S2 \leqq 19 \text{ cm}$$

vorzugsweise

$$5 \text{ cm} \leqq I \leqq 15 \text{ cm}$$
$$d \geqq 2 \text{ cm}$$
$$0 \leqq S1 \leqq 13 \text{ cm}$$
$$0 \leqq S2 \leqq 13 \text{ cm}$$

wobei I, S1, S2 und d in der Beziehung $I = S1 + S2 + d$ zueinander stehen, I der Abstand zwischen der vorderen Oberkante der ersten Düse (217) und der hinteren Oberkante der zweiten Düse (218) ist, S1 und S2 die Längen der ersten und zweiten Steuerplatten (201, 202) sind und d der Abstand zwischen entsprechenden Kanten der ersten und zweiten Steuerplatten (201, 202) ist.

5. Vorrichtung nach Anspruch 1, dadurch gekennzeichnet, daß der tangentiale Winkel an einer Hinterkante im Bereich einer Aussprudelöffnung der ersten Düse (317) im Bereich von 2° bis 80°, vorzugsweise von 5° bis 60° liegt.

6. Vorrichtung nach einem oder mehreren der vorstehenden Ansprüche, dadurch gekennzeichnet, daß die ersten und zweiten Düsen (17, 18; 117, 118; 217, 218; 317, 318) so im Verhältnis zu den Öffnungsflächen einfließenden Lotes ausgebildet sind, daß die entsprechenden Flächenverhältnisse durch die folgende Formel bestimmt sind:

$$\frac{A1}{A2} = K \frac{V1}{V2}$$

hierbei ist A1s die Öffnungsfläche einfließenden Lotes der ersten Düse (17; 117; 217) A2 die Öffnungsfläche einfließenden Lotes der zweiten Düse (18; 118; 218), bezogen auf die Transportrichtung der gedruckten Schaltungsplatine (4); V1 und V2 sind die entsprechenden inneren Volumina der ersten und zweiten Düsen (17, 18; 117, 118; 217, 218; 317, 318) vom Pegel des geschmolzenen Lotes bis zu den entsprechenden Ausflußöffnungen; und K ist ein Faktor im Bereich von 0,1 bis 1,2.

## Revendications

1. Appareil (G) destiné au soudage de composants (3) du type en pastilles sur des cartes de circuits imprimés (4), l'appareil comportant une première et une seconde buses (17, 18) indépendantes pour projetter de la soudure fondue (16) vers le haut de manière à former respectivement une première et une seconde vagues de soudure (36, 37) et un dispositif de transport qui maintient la carte de circuits imprimés (4) pour transporter ladite carte de circuits imprimés (4) de manière à en amener la surface inférieure en contact successif avec ladite première et ladite seconde vagues de soudure (36, 37) projettées par ladite première et ladite seconde buses (17, 18), ladite seconde vague de soudure (37) provenant de la seconde buse (18) située sur le côté aval étant agencée de manière que sa hauteur de crête soit plus haute que celle de ladite première vague de soudure (36) provenant de ladite première buse (17) située sur le côté amont par rapport au sens de transport de ladite carte de circuits imprimés (4), ladite première et ladite seconde buses (17, 18) étant agencées pour former ladite première et ladite seconde vagues de soudure (36, 37) circulant dans des sens opposés entre eux, ledit dispositif de transport étant agencé pour transporter ladite carte de circuits imprimés (4) dans une position inclinée sous un angle correspondant aux hauteurs de

9

ladite première et ladite seconde vagues de soudure (36, 37) de ladite première et ladite seconde buses (17, 18), caractérisé en ce que ladite première buse (17) est formée de manière que la première vague de soudure (36) ne soit projettée que dans le sens du mouvement de la carte de circuits imprimés (4) tandis que ladite seconde buse (18) est prévue avec une pièce de barrage (40) à son bord supérieur avant de manière à diriger la soudure fondue (16) formant ladite seconde vague de soudure (37) dans un sens opposé à celui du mouvement de la carte de circuits imprimés (4) et en ce que les orifices de projection (17a, 18a) de ladite première et ladite seconde buses (17, 18) sont disposés et formés de manière que des paquets excessifs de soudure (38, 39) formés sur le composant du type en pastilles (3) par la première vague de soudure (36) soient éliminés au passage par la seconde vague de soudure (37).

2. Appareil selon la revendication 1, caractérisé en ce que la distance entre le bord supérieur avant de ladite première buse (17) et le bord supérieur arrière de ladite seconde buse (18) est réglée de manière à se situer dans une plage supérieure à 3 cm et inférieure à 20 cm et de préférence encore, supérieure à 5 cm et inférieure à 15 cm.

3. Appareil selon la revendication 1, caractérisé en ce que le bord supérieur avant de ladite première buse (217) et le bord supérieur arrière de ladite seconde buse (218) sont prévus chacun avec une première et une seconde plaques de contrôle (201, 202), s'étendant l'une vers l'autre, avec une distance entre les bords correspondant de ladite première et ladite seconde plaques de contrôle (201, 202) réglée pour être supérieure à 1 cm et de préférence, supérieure à 2 cm.

4. Appareil selon la revendication 3, caractérisé en ce que les dimensions de ladite première et la seconde buses (217, 218) sont dans des relations telles que:

$$3 \text{ cm} \leqq l \leqq 20 \text{ cm}$$
$$d \geqq 1 \text{ cm}$$
$$0 \leqq S1 \leqq 19 \text{ cm}$$
$$0 \leqq S2 \leqq 19 \text{ cm}$$

et de préférence encore

$$5 \text{ cm} \leqq l \leqq 15 \text{ cm}$$
$$d \geqq 2 \text{ cm}$$
$$0 \leqq S1 \leqq 13 \text{ cm}$$
$$0 \leqq S2 \leqq 13 \text{ cm}$$

où l, S1, S2 et d étant dans la relation l=S1+S2+d, où l est la distance entre le bord supérieur avant de ladite première buse (217) et le bord supérieur arrière de ladite seconde buse (218), S1 et S2 sont chacun les longueurs de ladite première et ladite seconde plaques de contrôle (201, 202) et d est la distance entre les bords correspondant de ladite première et ladite seconde plaques de contrôle (201, 202).

5. Appareil selon la revendication 1, caractérisé en ce que l'angle de tangence au bord arrière au voisinage d'un orifice de projection de ladite première buse (317) se situe dans la plage de 2 à 80°C et de préférence encore de 5 à 60°.

6. Appareil selon l'une quelconque des revendications précédentes, caractérisé en ce que ladite première et ladite seconde buses (17, 18; 117, 118; 217, 218; 317, 318) sont agencées de manière que, dans la relation entre les surfaces d'orifices d'entrée de soudure fondue, les rapports respectifs de surfaces soient représentés par la formule:

$$\frac{A1}{A2} = K \frac{V1}{V2}$$

où A1 est la surface d'orifice d'entrée de soudure de la première buse (17, 117; 217), A2 est la surface d'entrée de soudure de la seconde buse (18; 118; 218) par rapport au sens du mouvement de la carte de circuits imprimés (4), V1 et V2 sont les volumes intérieurs respectifs des buses de ladite première et ladite seconde buses (17, 18; 117, 118; 217, 218; 317, 318) à partir du niveau de soudure fondue jusqu'aux orifices de sortie de soudure, et K est un facteur dans la plage de 0,1 à 1,2.

## Fig. 1 PRIOR ART

## Fig. 2 PRIOR ART

## Fig. 3

Characteristic deterioration occurrence rate (%)

Normal solder padding

Excessive solder padding

Printed circuit board deflection amount (mm) / 90mm length

## Fig. 4 PRIOR ART

## Fig. 5 PRIOR ART

Fig. 6

Fig. 7

Fig. 8

4

*Fig. 9*

*Fig. 10*

Fig. 11

Fig. 12

Fig. 13

*Fig. 14*

17B

α

*Fig. 15*

17C

β

Fig. 16

17D

Fig. 17

F

α

V1

V2

317

318

A1

A2